# FASCICULE DE BREVET EUROPEEN

(11) **EP 3 061 330 B1**
(45) Date de publication et mention de la délivrance du brevet: **13.09.2023**
(21) Numéro de dépôt: 14793829.4
(22) Date de dépôt: 28.10.2014
(51) Int. Cl.: H05K 7/20, F25B 27/02, G06F 9/50

(54) **UTILISATION DE MACHINES DE STIRLING POUR SYSTEME DE TRAITEMENT DE L'INFORMATION**
VERWENDUNG VON STIRLING-MOTOREN FÜR EIN INFORMATIONSVERARBEITUNGSSYSTEM
USE OF STIRLING ENGINES FOR INFORMATION PROCESSING SYSTEM

(30) Priorité: 24.10.2013 FR 1360368
(43) Date de publication de la demande: 31.08.2016
(73) Titulaire: BULL, 78340 Les Clayes Sous Bois (FR)
(72) Inventeur: MAUPU, Yann, 31400 Toulouse (FR)
(74) Mandataire: Novagraaf Technologies
(86) Numéro de dépôt international: PCT/EP2014/073149
(87) Numéro de publication internationale: WO 2015/082136

(56) Documents cités:
- EP-A1- 2 453 126
- CN-A- 102 346 537
- JP-A- 2009 299 568
- US-A1- 2005 078 447
- US-A1- 2010 146 996
- US-A1- 2011 096 503
- Kristian Fredslund ET AL: "GREEN DATA CENTER COOLING", , 19 août 2009 (2009-08-19), XP055130815, Extrait de l'Internet: URL:http://pire.soe.ucsc.edu/sites/default /files/Green_Data_Center_Cooling_report.pd f [extrait le 2014-07-22]

## Description

### DOMAINE DE L'INVENTION

L'invention concerne le domaine des systèmes de traitement de l'information. Elle s'applique notamment aux systèmes comprenant un grand nombre de dispositifs de traitement de l'information communément appelés « grappes » (ou « cluster » en langue anglaise) ou « fermes ».

### CONTEXTE DE L'INVENTION

Un dispositif de traitement de l'information est constitué d'un ensemble de circuits électriques permettant de traiter ou de mémoriser les informations. En général, ces circuits comprennent notamment des unités centrales de traitement dites CPU (Central Processing Unit), des mémoires RAM (Random Access Memory), et différents circuits généraux ou spécialisés interconnectés entre eux.

Il est connu de regrouper plusieurs dispositifs et de les connecter pour former des grappes (« clusters ») ou fermes. Ces fermes permettent de dépasser les limitations d'un dispositif isolé, donc d'offrir une meilleure disponibilité et des ressources plus importantes pour traiter des tâches confiées.

Ces grappes sont généralement mises en oeuvre sous la forme de baies comportant un ensemble de tiroirs dans lesquels sont disposés les dispositifs de traitement.

Les dispositifs de traitement de l'information peuvent être typiquement des ordinateurs, c'est-à-dire des dispositifs généralistes basés sur une ou plusieurs unités centrales de traitement (CPU). Dans ce cas, les grappes se voient typiquement confiées des tâches de calculs intensifs, par exemples dans le domaine scientifique ou bien en imagerie numérique.

Une autre application peut concerner le domaine des télécommunications. Dans ce cas, les dispositifs de traitement d'information peuvent être des routeurs, des commutateurs ou tout autre équipement unitaire manipulant des grands volumes d'information.

En général, les dispositifs de traitement de l'information comportent des circuits qui génèrent une importante déperdition d'énergie sous la forme de chaleur. Dans le cadre d'une ferme, cette perte en chaleur est d'autant plus importante que le nombre de dispositifs et donc de circuits est importants et que ceux-ci sont soumis à une charge de traitements importante.

Cette chaleur est inhérente au fonctionnement des circuits électriques et correspond à une consommation électrique. Cette énergie est généralement perdue et peut en outre endommager les circuits électriques lorsqu'elle provoque une température trop élevée.

Il est donc généralement prévu d'extraire une partie de la chaleur par des moyens de refroidissement permettant de l'évacuer vers l'extérieur du système de traitement de l'information.

Il peut être prévu alors d'utiliser cette énergie calorifique pour chauffer des locaux proches de système de traitement de l'information, mais cela ne présente pas toujours un grand intérêt.

Les demandes US2005/078447, et CN102346537, ainsi que l'article « Green data center cooling » de Kristian Fredslund et al, divulguent l'utilisation de machine de Stirling pour utiliser l'énergie calorifique, mais ces dispositifs engendrent des ajouts importants de mécanismes supplémentaires au système de traitement de l'information.

### RESUME DE L'INVENTION

Le but de l'invention est d'utiliser de façon plus efficace l'énergie calorifique générée par les circuits d'un système de traitement de l'information. Plus précisément, elle vise à abaisser la consommation électrique d'un tel système en utilisant de façon astucieuse cette énergie calorifique et de minimiser les ajouts de mécanismes supplémentaires au système de traitement de l'information

A cette fin, la présente invention propose un système de traitement de l'information conforme au jeu de revendications.

Un autre aspect de l'invention concerne un procédé conforme au jeu de revendications.

D'autres caractéristiques et avantages de l'invention apparaîtront à la lecture de la description qui suit d'un mode de réalisation préféré de l'invention, donnée à titre d'exemple et en référence aux dessins annexés.

### BREVE DESCRIPTION DES DESSINS

La figure 1 représente schématiquement une architecture possible pour un système de traitement de l'information selon un mode de réalisation de l'invention.
La figure 2 représente schématiquement un exemple de cycle thermodynamique de Stirling.
Les figures 3a à 3d illustrent schématiquement un exemple de machine de Stirling selon un mode de réalisation de l'invention à 4 moments du cycle thermodynamique de Stirling.
La figure 4 représente schématiquement un autre exemple de machine de Stirling selon un mode de réalisation de l'invention.

### DESCRIPTION DETAILLEE DE L'INVENTION

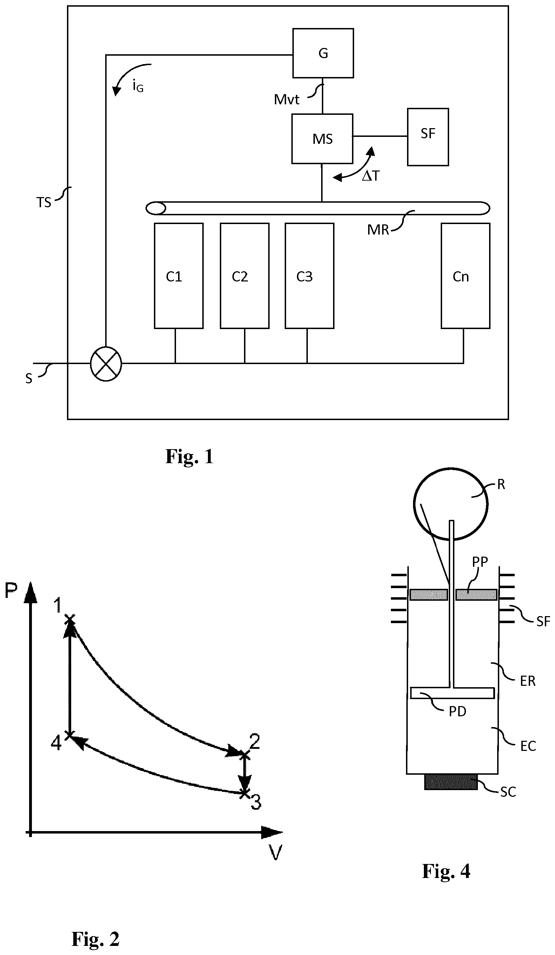

Le système de traitement de l'information TS représenté sur la figure 1 peut typiquement être une grappe (ou « cluster » en anglais) ou ferme de dispositifs de traitement de l'information.

Ces dispositifs forment une pluralité de circuits électriques C1, C2, C3... Cn. Les dispositifs de traitement de l'information eux-mêmes ne sont pas représentés sur la figure par soucis de clarté et parce que l'invention s'intéresse principalement aux circuits électriques dont ils sont composés.

Les circuits électriques composant un dispositif de traitement de l'information sont divers : il s'agit d'unités centrales de traitement (CPU pour « Central Processing Unit » en anglais), d'unités de traitement complémentaires, d'unités de traitement graphiques, de mémoires RAM (« Random Access Memory »), etc.

Les circuits électriques sont alimentés par une source d'alimentation S. Comme on le verra plus loin, selon un mode de réalisation de l'invention, un courant électrique i_{G} généré par un générateur G peut être réintroduit en parallèle du courant fourni par cette source S pour alimenter les circuits électrique.

Le système de traitement de l'information TS comporte en outre des moyens de refroidissement MR disposés à proximité d'au moins certains des circuits électriques.

Selon un mode de réalisation, les circuits électriques considérés sont uniquement les unités centrales de traitement (CPU).

Selon un autre mode de réalisation, les circuits électriques considérés sont l'ensemble des circuits électriques.

Selon un autre mode de réalisation, les circuits électriques considérés forment une partie substantielle d'entre eux.

La part des circuits électriques pris en compte peut dépendre de l'architecture matérielle du système de traitement de l'information. Ainsi, celui-ci peut être organisé dans une armoire, ou baie, et les moyens de refroidissements peuvent être à proximité des différents tiroirs de la baie, mais il peut être choisi de ne pas les disposer à proximité de certains tiroirs ou de certains circuits pour des considérations d'économie et de rentabilité. Il peut en effet être considéré suffisant de placer les moyens de refroidissement à proximité des circuits électriques chauffant le plus.

Selon un mode de réalisation, les moyens de refroidissement MR comportent des canalisations pour véhiculer un liquide caloporteur. Ce liquide caloporteur peut être de l'eau. Il peut être ajouté des additifs à cette eau afin d'abaisser la température de solidification ou éviter la formation d'algues.

Ces canalisations passent au plus près des circuits électriques considérés afin de capter au maximum la chaleur dégagée, avec une bonne efficacité calorimétrique.

L'agencement précis des moyens de refroidissement MR, ainsi que leur disposition relativement sortent du cadre de la présente invention et sont accessibles à l'homme de métier. Notamment, la notion de proximité dépend des moyens de refroidissement mis en oeuvre et peut être déterminée par l'homme du métier en fonction de la technologie employée.

L'invention consiste à prévoir deux circuits distincts de canalisation comme moyens de refroidissement MR :
- Un circuit primaire, c'est-à-dire par un premier circuit fermé en proximité ou contact direct avec les circuits électriques, notamment ceux produisant de la chaleur.
- Un circuit secondaire, c'est-à-dire un second circuit fermé en contact, ou à proximité, avec le circuit primaire. Il récupère ainsi la chaleur emmagasinée par le circuit primaire et l'amène vers l'extérieur du système de traitement de l'information TS.

Le système de traitement de l'information TS peut être localisé dans un emplacement dédié, une « salle de calcul » qui peut comporter d'autres systèmes de traitement de l'information. La température dans une telle salle est souvent élevée et il peut être prévu que le circuit secondaire emmène le liquide caloporteur à l'extérieur de cette salle.

Il peut être également prévu qu'il y soit refroidi par des radiateurs et/ou ventilateurs.

Le système de traitement de l'information TS comporte également une machine, ou moteur, de Stirling ST. Une telle machine permet de transformer une énergie thermique en énergie mécanique. L'énergie thermique est directement liée à un différentiel de température ΔT entre une source chaude et une source froide SF.

Selon l'invention, la source chaude est formée par les moyens de refroidissement MR. En effet, ceux-ci capturant la chaleur dégagée par les circuits électriques C1, C2, C3...Cn, ils sont substantiellement plus chauds que l'environnement.

La source froide SF doit permettre de créer un différentiel de température ΔT aussi important que possible. En effet, plus le différentiel est important et plus seront important l'énergie mécanique produite par la machine de Stirling ST et, par conséquent l'énergie électrique fournie par le générateur G.

La source froide SF peut donc être à distance des circuits électriques générant de la chaleur.

Dans la mesure où le système de traitement de l'information TS est généralement mise en oeuvre dans une armoire ou baie, ou dans un espace confiné, la température de cet espace est généralement supérieure à celle de l'extérieur. Aussi, il peut être prévu que la source froide soit localisée à proximité de l'extérieur du système de traitement de l'information TS. La source froide peut comporter en outre un radiateur et/ou un ventilateur afin d'améliorer la baisse de température.

Dans le cadre de l'invention telle que précédemment décrite, la source chaude SC est constituée par le circuit primaire, avant le contact avec le circuit secondaire ; et la source froide SF est constituée par ce circuit primaire après le contact avec le circuit secondaire.

D'autres arrangements sont bien évidemment possibles, de sorte à maximiser le différentiel de température ΔT. Le mode de réalisation décrit possède l'avantage de ne pas nécessiter d'ajout de mécanismes supplémentaires au système de traitement de l'information TS.

La machine de Stirling TS permet de convertir le différentiel de température ΔT en mouvement mécanique Mvt. Typiquement, ce mouvement mécanique Mvt est un mouvement de rotation, par exemple d'un axe ou d'une roue.

Une machine (ou un moteur) de Stirling est un moteur à énergie externe basé sur un fluide soumis à un cycle thermodynamique à 4 phases et inventé par Robert Stirling en 1816. Le fluide est généralement un gaz (air, hydrogène, hélium...).

Le cycle thermodynamique est illustré à la figure 2.

La courbe allant du point 1 au point 2 correspond à une détente isotherme. La zone est détente est chauffée par la source chaude SF. Le gaz suit une détente à température constante. Cette détente (augmentation du volume) permet de générer l'énergie mécanique. Comme la pression est élevée, l'énergie mécanique est importante.

La courbe allant du point 2 au point 3 correspond à un refroidissement à volume constant (isochore). Le gaz passe dans un autre espace de la machine de Stirling (le régénérateur) et se refroidit en lui transférant sa chaleur qui sera utilisée pour le cycle suivant.

La courbe allant du point 3 au point 4 correspond à un refroidissement isotherme. La zone de compression est refroidie, de sorte que le gaz subit une compression à température constante. Comme la pression est moindre qu'à l'étape de détente, l'énergie mécanique nécessaire pour cette compression est moins élevée et à chaque cycle on récolte donc un surplus d'énergie mécanique.

La courbe allant du point 4 au point 1 correspond à un chauffage isochore. Le gaz circule dans le régénérateur et prélève de la chaleur.

Ainsi, de l'énergie mécanique est générée, pouvant provoquer un mouvement mécanique Mvt, grâce au différentiel de pression entre les courbes allant des points 1 à 2 et 3 à 4. La production de cette énergie mécanique correspond à une consommation d'énergie thermique apportée par le différentiel de température ΔT.

Différentes mises en oeuvre de machines de Stirling existent. On peut notamment dénombrer trois grandes familles : les machines alphas, les machines betas et les machines gammas.

Selon un mode de réalisation préférentiel de l'invention, la machine de Stirling MS est une machine de Stirling de type alpha. La machine de type alpha présente l'avantage d'avoir un ratio puissance/encombrement élevé, et de ne pas avoir de pièces mobiles inaccessibles, de sorte que sa maintenance soit relativement aisée.

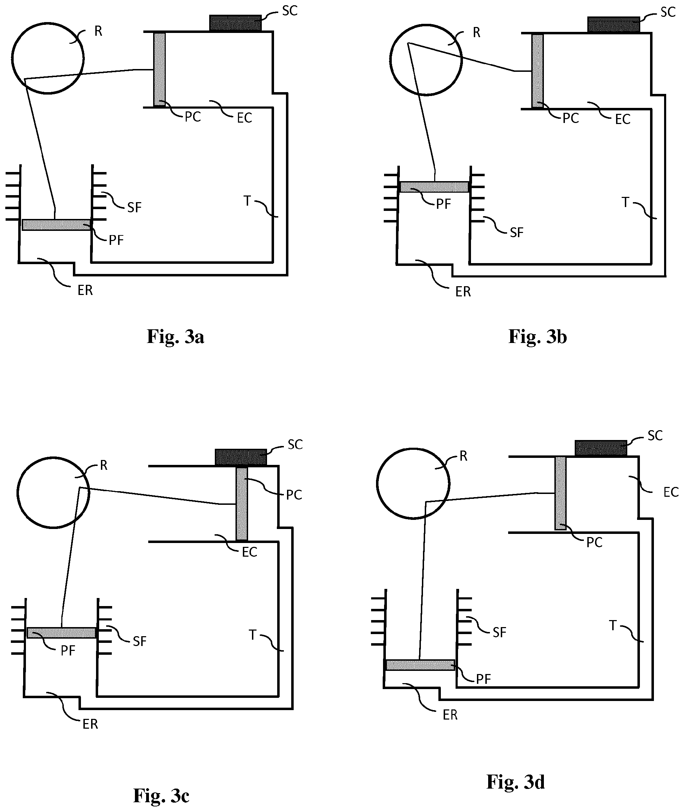

Les figures 3a, 3b, 3c et 3d illustrent une telle machine à 4 moments du cycle thermodynamique de Stirling.

Une machine de Stirling de type alpha comprend deux espaces, fermés chacun par un piston et reliés par un tuyau T :
- un espace de chauffage EC est fermé par un piston de puissance « chaud » PC et est en contact avec la source chaude SC, formée par les moyens de refroidissement, référencés MR sur la figure 1.
- Un espace de refroidissement ER est fermé par un piston de puissance « froid » PF et est en contact avec la source froide SF.

Les pistons chaud PC et froid PF sont mécaniquement reliés à une roue R, en un point excentré de celle-ci de sorte que le mouvement de translation des pistons soit converti en mouvement circulaire de la roue.

En outre la position des pistons est décalée de sorte que leurs cycles respectifs sont déphasés de 90°. Ainsi, de façon schématique, on voit que sur la figure 3a, par exemple, le piston chaud PC est en bout d'excursion tandis que le piston froid PF est à mi-course.

La roue R peut être un moyen équivalent, comme un axe, permettant de générer un mouvement rotatif sous l'action des mouvements conjugués des deux pistons PF, PC.

Dans une première phase du cycle thermodynamique de Stirling, le gaz est chauffé dans l'espace de chauffage EC par la source chaude SC. En chauffant, il tend à occuper davantage d'espace et pousse le piston chaud vers la gauche sur la figure, c'est-à-dire vers l'extrémité de l'espace de chauffage EC. Ce déplacement du piston chaud PC provoque la rotation de la roue R.

Dans le même temps, l'expansion du gaz tend à également pousser le piston froid PF, dont le cycle est en retard de 90° par rapport au cycle de l'espace de chauffage EC. La figure 3a illustre schématiquement la situation à l'issue de cette première phase.

Dans la situation illustrée par la figure 3b, le gaz a atteint son expansion maximale et le piston chaud PC « redescend » dans l'espace de chauffage EC (sur la figure, il va vers la droite) et pousse le gaz vers l'espace de refroidissement ER. Le piston froid continue donc de progresser vers l'extrémité de cet espace ER (selon son retard de 90°). La température du gaz s'abaisse puisqu'il est majoritairement en contact avec la source froide SF dans l'espace de refroidissement.

Sur la figure 3c, presque tout le gaz est dans le cylindre de refroidissement. La température continue de baisser, de même que sa pression. Le piston froid PF s'abaisse alors.

Sur la figure 3d, le gaz occupe son volume minimum. Le piston froid PF est totalement descendu dans l'espace de refroidissement, et le gaz est donc majoritairement dans l'espace de chauffage où il va se réchauffer en même temps que son volume augment. Le piston chaud PC est alors poussé vers la gauche et le cycle recommence.

Chaque mouvement des pistons PC, PF engendre des mouvements Mvt de rotation de la roue R, par l'intermédiaire de moyens de couplage mécanique entre les pistons et la roue.

Ce mouvement de rotation Mvt est transmis à un générateur G qui fournit un courant électrique i_{G} à partir de ce mouvement mécanique. Ce générateur peut être classique en soi

Selon l'invention, le courant i_{G} fourni par le générateur G est réintroduit en parallèle du courant fourni par la source d'alimentation S, afin d'alimenter la pluralité de circuits électrique.

De la sorte, le courant généré peut être facilement adapté, notamment en tension, aux conditions du système de traitement de l'information TS. En effet, notamment lorsque les moyens de refroidissement MR sont des moyens de refroidissement à liquide, la tension peut être abaissé à environ 40 V afin d'éviter les risques électriques en cas de rupture ou fuite d'une canalisation. Le générateur G peut alors directement fournir un courant électrique de tension adapté (donc, par exemple, 40 V).

Un avantage est de directement baisser la consommation électrique du système de traitement de l'information TS,

Selon un mode de réalisation, deux machines de Stirling MS sont agencées de sorte à produire un mouvement mécanique commun. Ces deux machines peuvent avoir les mêmes sources froide SF et chaude SC. Elles peuvent être agencées pour actionner la même roue R afin que leur puissance s'additionne : la puissance mécanique produite est ainsi deux fois plus importante.

La figure 4 illustre schématiquement une mise en oeuvre différente de la machine de Stirling MS de type « beta ».

La machine de type beta ne comporte qu'un seul espace sur lequel sont apposé les sources froide SF et chaude SC. Un piston de déplacement PD déplace le gaz entre un sous-espace de chauffage EC et un sous-espace de refroidissement ER. Ces deux sous-espaces appartiennent néanmoins bien à un même espace, c'est-à-dire un même élément matériel. Avec un décalage de phase, un piston de puissance PP est amené également à se déplacer (ici verticalement) le long de l'espace ER/EC et entraine, par couplage mécanique, la rotation d'une roue R ou d'un élément mécanique équivalent.

Bien entendu, la présente invention n'est pas limitée aux exemples et au mode de réalisation décrits et représentés, mais elle est susceptible de nombreuses variantes accessibles à l'homme de l'art.

## Revendications

1. Système de traitement de l'information (TS) comportant :
- un ensemble de dispositifs de traitement de l'information formant une pluralité de circuits électriques (C1, C2, C3...Cn) alimentés par une source d'alimentation (S),
- des moyens de refroidissement (MR) disposés à proximité d'au moins une partie - desdits circuits électriques et comportant des canalisations pour véhiculer du liquide caloporteur;
- au moins une machine de Stirling dont lesdits moyens de refroidissement (MR) forment une source chaude et produisant un mouvement mécanique (Mvt) à partir d'un différentiel de température (AT) entre ladite source chaude et une source froide (SF) ;et
- un générateur (G) fournissant un courant électrique (iG) à partir dudit mouvement mécanique,
**caractérisé en ce que**
lesdites canalisations desdits moyens de refroidissements (MR) comprennent deux circuits distincts de canalisation : un circuit primaire en proximité ou contact direct avec lesdits circuits électriques, et un circuit secondaire en contact, ou à proximité, avec ledit circuit primaire, qui récupère la chaleur emmagasinée par ledit circuit primaire ;
**en ce que** ladite source chaude (SC) est constituée par ledit circuit primaire avant le contact avec ledit circuit secondaire, et ladite source froide (SF) est constituée par ledit circuit primaire après le contact avec ledit circuit secondaire ;
et **en ce que** ledit générateur réintroduit le courant fourni en parallèle de la source d'alimentation (S).

2. Système de traitement de l'information selon la revendication précédente dans lequel ladite au moins une machine de Stirling est de type alpha.

3. Procédé pour un système de traitement de l'information (TS) comportant un ensemble de dispositifs de traitement de l'information formant une pluralité de circuits électriques (Cl, C2, C3 ...Cn) alimentés par une source d'alimentation (S), comportant
- une étape de refroidissement d'au moins une partie desdits circuits électriques, par des moyens de refroidissement (MR) comportant des canalisations pour véhiculer du liquide caloporteur, où lesdites canalisations desdits moyens de refroidissements MR comprennent deux circuits distincts de canalisation : un circuit primaire en proximité ou contact direct avec lesdits circuits électriques, et un circuit secondaire en contact, ou à proximité, avec ledit circuit primaire, qui récupère la chaleur emmagasinée par ledit circuit primaire ;
- Une étape de production d'un mouvement mécanique (Mvt) à partir d'un différentiel de température (AT) entre une source chaude (SC) et une source froide (SF) au moyen d'au moins une machine de Stirling dont lesdits moyens de refroidissement (MR) forment ladite source chaude ; et
- une étape de fourniture d'un courant électrique (iG) à partir dudit mouvement mécanique,
le procédé étant **caractérisé en ce qu'**on arrange ladite machine de Stirling de sorte queladite source chaude (SC) est constituée par ledit circuit primaire avant le contact avec ledit circuit secondaire, et ladite source froide (SF) est constituée par ledit circuit primaire après le contact avec ledit circuit secondaire, et **en ce que** ledit courant électrique est réintroduit en parallèle de la source d'alimentation (S).

4. Procédé selon la revendication 3 dans lequel ladite au moins une machine de Stirling est de type alpha.

## Patentansprüche

1. Informationsverarbeitungssystem (TS), umfassend:
- eine Gruppe von Informationsverarbeitungsvorrichtungen, die eine Vielzahl von elektrischen Schaltkreisen (C1, C2, C3...Cn) bilden, die von einer Stromquelle (S) gespeist werden,
- Kühlmittel (MR), die in der Nähe mindestens eines Teils der elektrischen Schaltkreise angeordnet sind und Leitungen zum Befördern von Wärmetauschfluid umfassen;
- mindestens einen Stirling-Motor, dessen Kühlmittel (MR) eine heiße Quelle bilden und der eine mechanische Bewegung (Mvt) aus einem Temperaturunterschied (AT) zwischen der heißen Quelle und einer kalten Quelle (SF) erzeugt; und
- einen Generator (G), der aus der mechanischen Bewegung einen elektrischen Strom (iG) bereitstellt,
**dadurch gekennzeichnet, dass**
die Leitungen der Kühlmittel (MR) zwei unterschiedliche Leitungskreisläufe aufweisen: einen Primärkreislauf, der sich in der Nähe oder in direktem Kontakt mit den elektrischen Schaltkreisen befindet, und einen Sekundärkreislauf, der sich in Kontakt oder in der Nähe des Primärkreislaufs befindet, der die von dem Primärkreislauf eingespeicherte Wärme zurückgewinnt;
**dadurch, dass** die heiße Quelle (SC) durch den Primärkreislauf vor dem Kontakt mit dem Sekundärkreislauf ausgebildet wird, und die kalte Quelle (SF) durch den Primärkreislauf nach dem Kontakt mit dem Sekundärkreislauf ausgebildet wird;
und **dadurch, dass** der Generator den bereitgestellten Strom parallel zu der Stromquelle (S) zurückführt.

2. Informationsverarbeitungssystem nach dem vorstehenden Anspruch, wobei der mindestens eine Stirling-Motor von einem Alpha-Typ ist.

3. Verfahren für ein Informationsverarbeitungssystem (TS), das eine Gruppe von Informationsverarbeitungsvorrichtungen umfasst, die eine Vielzahl von elektrischen Schaltkreisen (C1, C2, C3, ...Cn) bilden, die von einer Stromquelle (S) gespeist werden, umfassend
einen Schritt einer Kühlung mindestens eines Teils der elektrischen Schaltkreise durch Kühlmittel (MR), umfassend Leitungen zum Befördern von Wärmetauschfluid, wobei die Leitungen der Kühlmittel MR zwei unterschiedliche Leitungskreisläufe aufweisen: einen Primärkreislauf in der Nähe oder in direktem Kontakt mit den elektrischen Schaltkreisen und einen Sekundärkreislauf in Kontakt oder in der Nähe des Primärkreislaufs, der die von dem Primärkreislauf eingespeicherte Wärme zurückgewinnt;
- einen Schritt des Erzeugens einer mechanischen Bewegung (Mvt) aus einem Temperaturunterschied (AT) zwischen einer heißen Quelle (SC) und einer kalten Quelle (SF) mithilfe von mindestens einem Stirling-Motor, dessen Kühlmittel (MR) die heiße Quelle bilden; und
- einen Schritt des Bereitstellens eines elektrischen Stroms (iG) aus der mechanischen Bewegung,
wobei das Verfahren **dadurch gekennzeichnet ist, dass** der Stirling-Motor so ausgelegt ist, dass die heiße Quelle (SC) durch den Primärkreislauf vor dem Kontakt mit dem Sekundärkreislauf ausgebildet wird und die kalte Quelle (SF) durch den Primärkreislauf nach dem Kontakt mit dem Sekundärkreislauf ausgebildet wird, und **dadurch, dass** der elektrische Strom parallel zu der Stromquelle (S) zurückgeführt wird.

4. Verfahren nach Anspruch 3, wobei der mindestens eine Stirling-Motor von dem Alpha-Typ ist.

## Claims

1. Information processing system (TS) comprising:
- a set of information processing devices which form a plurality of electrical circuits (Cl, C2, C3 ... Cn) powered by a power source (S),
- cooling means (MR) which are arranged near at least part of said electrical circuits and comprise pipes for conveying heat-transport liquid;
- at least one Stirling engine, the cooling means (MR) of which form a heat source, and which engine produces a mechanical movement (Mvt) from a temperature differential (AT) between said heat source and a cold source (SF); and
- a generator (G) which provides an electric current (iG) from said mechanical movement,
**characterized in that**
said pipes of said cooling means (MR) have two separate pipe circuits: a primary circuit which is near to or in direct contact with said electrical circuits, and a secondary circuit which is in contact with, or near to, said primary circuit and recovers the heat stored by said primary circuit;
**in that** said heat source (SC) consists of said primary circuit before contact with said secondary circuit, and said cold source (SF) consists of said primary circuit after contact with said secondary circuit;
and **in that** said generator reintroduces the current which is supplied in parallel with the power source (S).

2. Information processing system according to the preceding claim, wherein said at least one Stirling engine is of the alpha type.

3. Method for an information processing system (TS) comprising a set of information processing devices which form a plurality of electrical circuits (Cl, C2, C3 ... Cn) powered by a power source (S), the method comprising
- a step of cooling at least part of said electrical circuits using cooling means (MR) comprising pipes for conveying heat-transport liquid, where said pipes of said cooling means MR have two separate pipe circuits: a primary circuit which is near to or in direct contact with said electrical circuits, and a secondary circuit which is in contact with, or near to, said primary circuit and recovers the heat stored by said primary circuit;
- a step of producing a mechanical movement (Mvt) from a temperature differential (AT) between a heat source (SC) and a cold source (SF) by means of at least one Stirling machine, the cooling means (MR) of which form said heat source; and
- a step of supplying an electric current (iG) from said mechanical movement,
the method being **characterized in that** said Stirling machine is arranged so that said heat source (SC) consists of said primary circuit before contact with said secondary circuit, and said cold source (SF) consists of said primary circuit after contact with said secondary circuit, and **in that** said electric current is reintroduced in parallel with the power source (S).

4. Method according to claim 3, wherein said at least one Stirling engine is of the alpha type.
